# EUROPEAN PATENT APPLICATION

(11) **EP 4 067 794 A1**
(43) Date of publication of application: **05.10.2022**
(21) Application number: 22162060.2
(22) Date of filing: 15.03.2022
(51) Int. Cl.: F25D 29/00, F24C 7/08

(54) **CONTROL BOX COMPONENT**

(30) Priority: 02.04.2021 CN 202110359104
(71) Applicant: BSH Hausgeräte GmbH, 81739 München (DE)
(72) Inventor: Liu, Haiyan, Nanjing, 210000 (CN); Liu, Junxin, Chuzhou, 239000 (CN)

(57) **Abstract**

A control box assembly (1) includes a control panel (10) and a housing (11). At least part of the control panel is disposed in the housing. The housing has an opening (111). The part of the control panel located in the housing includes a first terminal (101). The first terminal is located at the opening or in a projection area of the opening facing inside of the housing. The control box assembly further includes a plug fixing portion (12). The plug fixing portion is detachably connected to the housing to reveal or cover the opening. The plug fixing portion includes at least one first fixing portion (121). The first fixing portion is configured to fix a second terminal. The second terminal is electrically connected to the first terminal when the plug fixing portion is connected to the housing. By means of the solution of the present invention, a number of times of inserting and removing the terminal connected to the control panel during production and assembling can be reduced. In this way, the assembling efficiency is improved and the defect rate caused by the frequent insertion and removal of the terminal is reduced.

## Description

### TECHNICAL FIELD

Embodiments of the present invention relate to the technical field of a control box, and in particular, to a control box assembly.

### BACKGROUND

Nowadays, household appliances such as refrigerators, washing machines become irreplaceable devices in daily life of people. With the advancement of science and technology and the users' pursuit for operation convenience, intelligentization of the household appliances becomes a current technological hot point.

Circuit control and intelligent control of household appliances rely on a control panel disposed in the household appliances. Therefore, as an indispensable component, the control panel plays a vital role in the normal operation of the household appliances, and may even be called a "brain" of the household appliances. Each component of the household appliances is connected to the control panel by a wire harness, so that the control panel can control functional operation of each component.

At present, generally, a household appliance manufacturer inserts terminals of the wire harnesses connecting the components into a terminal fixing portion of the control box one by one at a final assembling stage, so as to ensure effective electrical connection between each component and the control panel in the control box.

However, the control box generally not only have the control panel disposed therein, but also accommodates other circuit components such as a communication module. These components are pre-assembled by means of connection to a terminal fixing portion of the control box by the wire harness before delivery of the control box. As a result, during final assembling, the household appliance manufacturer is required to remove the wire harness already connected to the control box, insert the wire harness of each component of the home appliances into the terminal fixing portion, and then insert the wire harness connecting the circuit components in the control box into the terminal fixing portion. The mounting requiring frequent insertion and removal not only seriously affects the assembling efficiency, but also easily causes a high defect rate.

### SUMMARY

Embodiments of the present invention are intended to provide an improved control box assembly.

Therefore, the embodiments of the present invention provide a control box assembly. The control box assembly includes a control panel and a housing. At least part of the control panel is disposed in the housing. The housing has an opening. The part of the control panel located in the housing includes a first terminal. The first terminal is located at the opening or in a projection area of the opening facing inside of the housing. The control box assembly further includes a plug fixing portion. The plug fixing portion is detachably connected to the housing to reveal or cover the opening. The plug fixing portion includes at least one first fixing portion. The first fixing portion is configured to fix a second terminal. The second terminal is electrically connected to the first terminal when the plug fixing portion is connected to the housing.

By means of this implementation, a number of times of inserting and removing the terminal connected to the control panel during production and assembling can be reduced. In this way, the assembling efficiency is improved and the defect rate caused by the frequent insertion and removal of the terminal is reduced. Specifically, the plug fixing portion is detachably connected to the housing. In this way, the plug fixing portion can be pre-assembled independent of the housing. For example, the second terminal may be pre-fixed to the plug fixing portion to realize pre-assembling. Then the plug fixing portion and the second terminal may be mounted to the housing together during the assembling, so as to realize electrical connection between the second terminal and the first terminal.

In a possible embodiment, the first terminal includes a conductive contact piece, and the second terminal includes a snap opening that is at least partially conductive. The conductive part of the snap opening is in physical contact with the conductive contact piece when the plug fixing portion is connected to the housing. In this way, efficient electrical connection is realized between the first terminal and the second terminal.

In a possible embodiment, the conductive contact piece is located on an edge of the control panel close to the opening, so as to effectively come into contact with the second terminal fixed at the opening by the first fixing portion and ensure the effective electrical connection between the conductive contact piece and the second terminal.

In a possible embodiment, the control box assembly further includes a third terminal electrically connected to the first terminal, and the plug fixing portion includes an avoidance groove. The third terminal is located in the avoidance groove when the plug fixing portion is connected to the housing. By means of the avoidance groove, the third terminal can avoid the plug fixing portion or the second terminal fixed to the plug fixing portion to be electrically connected to the first terminal, and the plug fixing portion can be mounted without a special need to insert or remove the third terminal during the assembling.

In a possible embodiment, the avoidance groove is provided on a side of the plug fixing portion facing the opening and extends away from the control panel. During the assembling, the third terminal may be directly snapped into the edge of the control panel to be electrically connected to the first terminal, and the plug fixing portion avoids the third terminal by means of the avoidance groove when being mounted to the housing. In this way, the mounting of the plug fixing portion and the mounting of the third terminal do not affect each other. Therefore, there is no special need to insert or remove the third terminal to mount the plug fixing portion or the second terminal fixed to the plug fixing portion.

In a possible embodiment, the avoidance groove includes a snapping portion. The third terminal is snapped-fitted to the avoidance groove to be electrically connected to the first terminal when the plug fixing portion is connected to the housing. During the assembling, the third terminal is first snapped into the avoidance groove, and is then mounted to the housing together with the plug fixing portion to be electrically connected to the first terminal.

In a possible embodiment, the avoidance groove is in communication with the at least one first fixing portion. When the plug fixing portion is connected to the housing, the second terminal and/or the third terminal are/is snapped into the avoidance groove or the first fixing portion to be electrically connected to the first terminal. In this way, the second terminal and the third terminal may be inserted from the avoidance groove side or the first fixing portion side according to an actual need to be electrically connected to the first terminal. Therefore, the assembling is flexible.

In a possible embodiment, an opening direction of the avoidance groove is opposite to an opening direction of the at least one first fixing portion, so as to meet the connection requirements of different terminals. For example, a terminal of a first to-be-connected member disposed in the housing may be inserted into the avoidance groove. In this way, the first to-be-connected member can be completely electrically connected to the first terminal in the housing. For another example, a terminal of a second to-be-connected member disposed outside the housing may be inserted into the first fixing portion, so as to realize electrical connection to the first terminal outside the housing.

In a possible embodiment, the control box assembly further includes a first to-be-connected member. The first to-be-connected member is disposed in the housing. When the plug fixing portion is connected to the housing, the first to-be-connected member is electrically connected to the first terminal by the third terminal. In this way, the first to-be-connected member disposed in the housing is completely electrically connected to the first terminal in the housing.

In a possible embodiment, the first to-be-connected member is located above or below the control panel. A projection area of the first to-be-connected member facing the control panel at least partially overlaps with the control panel. Therefore, a space utilization of the housing is high, thereby facilitating miniaturization of the control box assembly.

In a possible embodiment, the third terminal is inserted into the first fixing portion along a first direction and is electrically connected to the first terminal. The first direction is a direction in which the plug fixing portion points to the control panel. Therefore, the third terminal and the second terminal are inserted into the plug fixing portion in a same direction.

In a possible embodiment, a wall of the housing on which the opening is provided has an accommodating portion. The accommodating portion is configured for the wire harness to span. When the plug fixing portion is connected to the housing. A part of the wire harness is located in the housing, a remaining part of the wire harness spans the accommodating portion to outside of the housing, and an end portion of the wire harness outside the housing forms the third terminal. In this way, the accommodating portion can protect the wire harness. In particular, the accommodating portion protects the part of the wire harness spanning over the wall of the housing from being squeezed and damaged by an external force.

In a possible embodiment, the plug fixing portion includes a body. The first fixing portion is formed by a through hole running through the body along a first direction. The first direction is a direction in which the plug fixing portion points to the control panel. In this way, the second terminal can be fixed to the first fixing portion along the first direction, and is effectively electrically connected to the first terminal when the plug fixing portion is connected to the housing.

In a possible embodiment, the housing includes a buckling portion, and the plug fixing portion includes a buckling mating portion. The buckling portion is mated with the buckling mating portion to detachably connect the plug fixing portion to the housing. The connection between the buckling portion and the buckling mating portion is simple, thereby improving the operation convenience during the assembling and improving the assembling efficiency.

In a possible embodiment, the buckling mating portion includes a first buckling mating portion located on one end of the plug fixing portion and a second buckling mating portion located on an other end of the plug fixing portion. The buckling portion includes a first buckling portion adapted to the first buckling mating portion and a second buckling portion adapted to the second buckling mating portion. In this way, both ends of the plug fixing portion are detachably connected to the housing, thereby ensuring that the plug fixing portion is connected to the housing firmly.

In a possible embodiment, the first buckling portion is a T-shaped member or an L-shaped member, and the first buckling mating portion is a U-shaped member. When an opening of the U-shaped member is inserted into a longitudinal section of the T-shaped member or the L-shaped member, an end portion of the U-shaped member abuts against a transverse section of the T-shaped member or the L-shaped member. By means of the mating between the T-shaped member and the U-shaped member or the mating between the L-shaped member and the U-shaped member, the plug fixing portion is ensured not to move unexpectedly after being connected to the housing.

In a possible embodiment, each of the buckling mating portions includes a deformable portion. The deformable portion is bendable or compressible by an external force to fix the plug fixing portion to the housing by means of elastic deformation.

In a possible embodiment, the deformable portion includes a plurality of elastic pieces connected end to end. An included angle ranging from 0 degrees to 90 degrees exists between two connected elastic pieces. The deformable portion formed by the plurality of elastic pieces telescopic between each other can fix the plug fixing portion to the housing by means of elastic deformation.

In a possible embodiment, when the plug fixing portion is connected to the housing, the deformable portion is in a bent or compressed state, so as to ensure that the plug fixing portion is always firmly connected to the housing.

In a possible embodiment, the buckling portion includes a hook portion bent toward the buckling mating portion. When the plug fixing portion is connected to the housing, the deformable portion hooks the hook portion, so as to avoid an unexpected movement of the plug fixing portion after being connected to the housing.

### BRIEF DESCRIPTION OF THE DRAWINGS

FIG. 1 is a schematic diagram of a control box assembly according to an embodiment of the present invention.
FIG. 2 is an exploded view of the control box assembly shown in FIG. 1.
FIG. 3 is a schematic diagram of a plug fixing portion in FIG. 1.
FIG. 4 is a partial enlarged view of a region A in FIG. 1.
FIG. 5 is a partial enlarged view of a region B in FIG. 1.

In the accompanying drawings:
1-Control box assembly; 10-Control panel; 101-First terminal; 102-Conductive contact piece; 11-housing; 11a-Wall of housing; 111-Opening; 112-Accommodating portion; 113-Buckling portion; 114-First buckling portion; 115-Second buckling portion; 116-Hook portion; 117-Stop portion; 12-Plug fixing portion; 12a-One end of plug fixing portion; 12b-Other end of plug fixing portion; 121-First fixing portion; 122-Avoidance slot; 123-Snapping portion; 124-Body; 125-Through hole; 126-Buckling mating portion; 127-First buckling mating portion; 128-Second buckling mating portion; 129-Deformable portion; 13-Third terminal; 14-First to-be-connected member; 15-Wire harness; 16-Front panel 17-Fixing frame; y-First direction; z-Second direction.

### DETAILED DESCRIPTION

To make the foregoing objectives, features, and advantages of the present invention clearer and easier to understand, specific embodiments of the present invention are described below in detail with reference to the accompanying drawings.

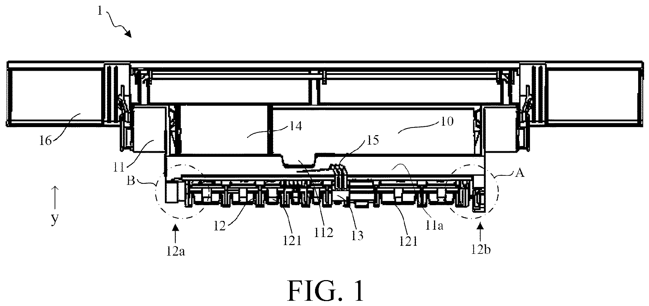

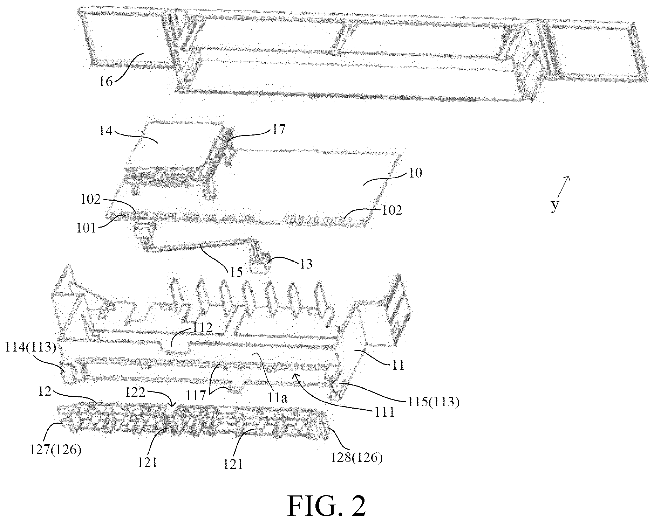

FIG. 1 is a schematic diagram of a control box assembly according to an embodiment of the present invention. FIG. 2 is an exploded view of the control box assembly shown in FIG. 1.

The control box assembly 1 in this implementation may be disposed in a household appliance to be used as a control unit of the household appliance to control functional operation of each component in the household appliance. For example, the household appliance may include a refrigerator. The control box assembly 1 is disposed in the refrigerator. A control panel 10 in the control box assembly 1 is electrically connected to components such as a compressor of the refrigerator. The control panel 10 is adapted to control functional operation of the compressor. Some circuit components of the household appliance may be integrated in the control box assembly 1. For example, a communication module of the refrigerator may be integrated in the control box assembly 1 and is electrically connected to the control panel 10. The control panel 10 communicates with an external intelligent device by using the communication module.

In this implementation, circuit components in the housing 11 required to be electrically connected to the control panel 10 are collectively referred to as a first to-be-connected member 14, and circuit components outside the housing 11 required to be electrically connected to the control panel 10 are collectively referred to as a second to-be-connected member (not shown in the FIG.).

Specifically, referring to FIG. 1 and FIG. 2, the control box assembly 1 may include a control panel 10 and a housing 11. At least part of the control panel 10 is disposed in the housing 11. For example, the control panel 10 may be a printed circuit board (PCB for short). For example, the housing 11 may be disposed around at least three edges of the control panel 10 and support the control panel 10 from a bottom. Further, the control box assembly 1 may include a front panel 16 adapted to mated with the housing 11 to enclose the control panel 10.

Further, the housing 11 may have an opening 111. The opening 111 may be provided in a wall 1 1a of the housing 11 on a side away from the front panel 16.

In a specific implementation, the part of the control panel 10 located in the housing 11 may include a first terminal 101. The first terminal 101 is located at the opening 111.

Specifically, the first terminal 101 may include a conductive contact piece 102. For example, the conductive contact piece 102 may be made of a metal material such as copper.

Further, the conductive contact piece 102 may be located on an edge of the control panel 10 close to the opening 111, so as to effectively come into contact with the second terminal (not shown in the FIG.) fixed to the opening 111 by the first fixing portion 121 and ensure effective electrical connection between the conductive contact piece and the second terminal. For example, the conductive contact piece 102 may include a plurality of conductive contact pieces spaced apart from each other on the edge of the control panel 10 close to the opening 111.

Alternatively, the first terminal 101 may be located in a projection area of the opening 111 facing inside of the housing 11. In a specific implementation, the control box assembly 1 may further include a plug fixing portion 12. The plug fixing portion 12 is detachably connected to the housing 11 to reveal or cover the opening 111.

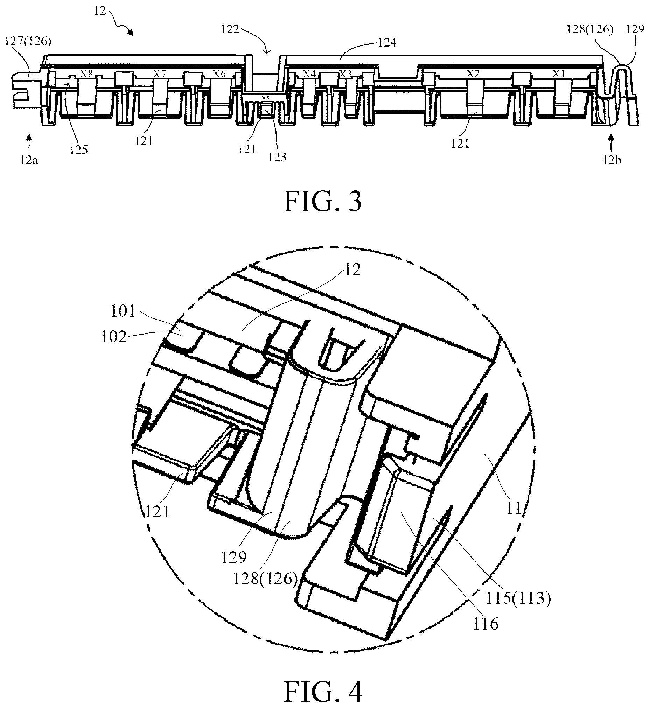

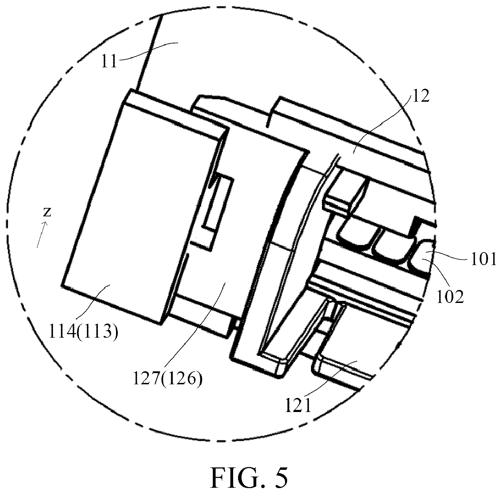

Specifically, referring to FIG, 2 to FIG. 5, the housing 11 may include a buckling portion 113, and the plug fixing portion 12 may include a buckling mating portion 126. The buckling portion 113 is mated with the buckling mating portion 126 to detachably connect the plug fixing portion 12 to the housing 11. The connection between the buckling portion 113 and the buckling mating portion 126 is simple, thereby improving the operation convenience during the assembling and improving the assembling efficiency. FIG. 3 is a schematic diagram of the plug fixing portion in FIG. 1. FIG. 4 is a partial enlarged view of a region A in FIG. 1. FIG. 5 is a partial enlarged view of a region B in FIG. 1.

Further, the buckling mating portion 126 may include a first buckling mating portion 127 located on one end 12a of the plug fixing portion 12 and a second buckling mating portion 128 located on an other end 12b of the plug fixing portion 12. Correspondingly, the buckling portion 113 may include a first buckling portion 114 adapted to the first buckling mating portion 127 and a second buckling portion 115 adapted to the second buckling mating portion 128. Therefore, both ends of the plug fixing portion 12 are detachably connected to the housing 11, thereby ensuring that the plug fixing portion 12 is connected to the housing 11 firmly.

For example, the first buckling portion 114 may be a T-shaped member, and the first buckling mating portion 127 may be a U-shaped member. A longitudinal section of the T-shaped member protrudes outward from the housing 11 and is connected to a transverse section of the T-shaped member with an end. The opening of the U-shaped member is inserted into a gap between the transverse section of the T-shaped member and the housing 11, and the longitudinal section of the T-shaped member falls into the opening of the U-shaped member to prevent a relative movement between the plug fixing portion 12 and the housing 11 in a second direction (a z direction in the figure). The second direction is a direction from one end portion of the U-shaped member points to an other end portion.

Further, a length of the transverse section of the T-shaped member along the z direction may be greater than a length of the longitudinal section of the T-shaped member along the z direction. When the opening of the U-shaped member is inserted into the longitudinal section of the T-shaped member, an end portion of the U-shaped member abuts against the transverse section of the T-shaped member, so as to prevent a relative movement between the plug fixing portion 12 and the housing 11 in a first direction (a y direction in the figure). The first direction is a direction in which the plug fixing portion 12 points to the control panel 10. Alternatively, the first buckling mating portion 127 may be an L-shaped member. One edge of the L-shaped member corresponds to the longitudinal section of the T-shaped member, and an other edge of the L-shaped member corresponds to the transverse section of the above T-shaped member.

Therefore, by means of the mating between the T-shaped member and the U-shaped member or the mating between the L-shaped member and the U-shaped member, the plug fixing portion 12 is ensured not to move unexpectedly after being connected to the housing 11.

For another example, the buckling mating portion 126 may include a deformable portion 129. The deformable portion 129 is bendable or compressible by an external force to fix the plug fixing portion 12 to the housing 11 by means of elastic deformation.

The deformable portion 129 may include a plurality of elastic pieces connected end to end. An included angle ranging from 0 degrees to 90 degrees may exist between two connected elastic pieces. In the illustrated embodiment, three elastic pieces connected end to end are exemplified. During practical application, a number of the elastic pieces may be adjusted as required.

Therefore, the deformable portion 129 formed by the plurality of elastic pieces telescopic between each other can fix the plug fixing portion 12 to the housing 11 by means of elastic deformation.

Further, when the deformable portion 129 is in a loosened state, a length of the plug fixing portion 12 may be slightly larger than a distance from the first buckling portion 114 to the second buckling portion 115. During assembling, first, the deformable portion 129 may be pressed against the second buckling portion 115, and a force is applied toward the second buckling portion 115 until the deformable portion 129 is compressed or bent. Then, the opening of the U-shaped member is inserted into the longitudinal section of the T-shaped member, so as to assemble the plug fixing portion 12 to the housing 11.

Further, when the plug fixing portion 12 is connected to the housing 11, the deformable portion 129 may be in a bent or compressed state to tightly press the opening of the U-shaped member against the longitudinal section of the T-shaped member, thereby ensuring that the plug fixing portion 12 is always firmly connected to the housing 11.

In a specific implementation, the buckling portion 113 may include a hook portion 116 bent toward the buckling mating portion 126. When the plug fixing portion 12 is connected to the housing 11, the deformable portion 129 hooks the hook portion 116, so as to avoid an unexpected movement of the plug fixing portion 12 after being connected to the housing 11.

Specifically, an outermost elastic piece of the deformable portion 129 is clamped between the housing 11 and the hook portion 116, thereby preventing a relative movement between the plug fixing portion 12 and the housing 11 in the y direction.

For example, the second buckling portion 115 may be formed by a groove extending outward from the housing 11 and recessed toward the end 12a of the plug fixing portion 12. Along the y direction, two elongated notches spaced apart from each other in a direction from an end of a bottom wall of the groove to the housing 11. A part between the notches is bent inward at the end of the bottom wall of the groove to form the hook portion 116. During the assembling, when the outermost elastic piece of the deformable portion 129 abuts against the hook portion 116, the hook portion 116 can be deformed slightly along the notches. In this way, the deformable portion 129 can be fixed to the hook portion 116 more effortlessly.

Further, two sides of the groove along the z direction are adapted to provide guiding during mounting of the deformable portion 129 to the hook portion 116.

In a specific implementation, along the z direction, the housing 11 may have stop portions 117 provided on both an upper side and a lower side of the opening 111 to prevent the movement of the plug fixing portion 12 along the z direction when the plug fixing portion 12 is connected to the housing 11.

For example, a length of the stop portion 117 located below the opening 111 may be shorter than a length of the stop portion 117 located above the opening 111.

Thus, the stop portions 117, the hook portion 116, and the T-shaped member are mated to fix the plug fixing portion 12 to the housing 11 circumferentially.

In a specific implementation, still referring to FIG. 2 and FIG. 3, the plug fixing portion 12 may include at least one first fixing portion 121. The first fixing portion 121 is configured to fix a second terminal (not shown in the figure). The second terminal is electrically connected to the first terminal 101 when the plug fixing portion 12 is connected to the housing 11.

In the figures, a total of eight first fixing portions 121 which are referenced as X1 to X8 are exemplified. However, during practical application, a number of the first fixing portions 121 included in the plug fixing portion 12 may be adjusted according to an actual need.

Further, the first fixing portions 121 may be disposed side by side on the plug fixing portion 12.

Further, a distance between at least two of the first fixing portions 121 may be different from a distance between other first fixing portions 121.

Further, the plug fixing portion 12 may include a body 124. The first fixing portion 121 is formed by a through hole 125 running through the body 124 in the y direction. In this way, the second terminal can be fixed to the first fixing portion 121 in the y direction, and is effectively electrically connected to the first terminal when the plug fixing portion 12 is connected to the housing 11.

Further, a size of at least one through hole 125 may be different from a size of an other through hole 125. For example, a corresponding size of the through hole 125 may be determined according to the size of the to-be-fixed second terminal.

A specific location on the edge of the control panel 10 close to the opening 111 where the first terminal 101 is disposed may be adapted to a location and a size of a corresponding first fixing portion 121. In this way, the second terminal inserted into the first fixing portion 121 can be electrically connected to the first terminal 101 effectively.

In a specific implementation, the second terminal may be used to conduct the second to-be-connected member and the first terminal 101. The second terminal may include a snap opening that is at least partially conductive, and the conductive part of the snap opening is in physical contact with the conductive contact piece 102 when the plug fixing portion 12 is connected to the housing 11. In this way, efficient electrical connection is realized between the first terminal 101 and the second terminal.

For example, the snap opening is inserted into the first fixing portion 121 to be snapped-fitted to the first fixing portion 121, and the conductive part of the snap opening is in physical contact with the conductive contact piece 102.

Further, a different first fixing portion 121 may be configured to fix and conduct a second terminal of a different second to-be-connected member in a household appliance.

In a specific implementation, still with reference to FIG. 1 and FIG. 2, the control box assembly 1 may further include a third terminal 13 electrically connected to the first terminal 101. The third terminal 13 may be configured to conduct the first to-be-connected member 14. A shape of the second terminal may be similar to a shape of the third terminal 13 shown in the figure.

Specifically, the plug fixing portion 12 may include an avoidance groove 122. The third terminal 13 is located in the avoidance groove 122 when the plug fixing portion 12 is connected to the housing 11. By means of the avoidance groove 122, the third terminal 13 can avoid the plug fixing portion 12 or the second terminal fixed to the plug fixing portion 12 to be electrically connected to the first terminal 101, and the plug fixing portion 12 can be mounted without a special need to insert or remove the third terminal 13 during the assembling.

Further, the first to-be-connected member 14 is disposed in the housing 11. One end of the wire harness 15 disposed in the housing 11 is electrically connected to the first to-be-connected member 14, and an other end (that is, the third terminal 13) of the wire harness 15 is electrically connected to the first terminal 101. In addition, when the plug fixing portion 12 is connected to the housing 11, the third terminal 13 is located in the avoidance groove 122. In this way, the first to-be-connected member 14 can be completely electrically connected to the first terminal 101 in the housing 11.

In a specific implementation, the avoidance groove 122 may be provided on a side of the plug fixing portion 12 facing the opening 111 and extends away from the control panel 10.

During the assembling, the third terminal 13 may be directly snapped into the edge of the control panel 10 to be electrically connected to the first terminal 101, and the plug fixing portion 12 avoids the third terminal 13 by means of the avoidance groove 122 when being mounted to the housing 11. In this way, the mounting of the plug fixing portion 12 and the mounting of the third terminal 13 do not affect each other. Therefore, there is no special need to insert or remove the third terminal 13 to mount the plug fixing portion 12 or the second terminal fixed to the plug fixing portion 12.

In a variation, the avoidance groove 122 may include a snapping portion 123. The third terminal 13 may be snapped-fitted to the avoidance groove 122 to be electrically connected to the first terminal 101 when the plug fixing portion 12 is connected to the housing 11.

For example, a structure of the snapping portion 123 may be similar to a structure in the first fixing portion 121 to be snapped-fitted to the second terminal, and is configured to hook the third terminal 13 when the third terminal 13 is inserted into the avoidance groove 122.

During the assembling, the third terminal 13 is first snapped into the avoidance groove 122 to be snapped-fitted to the snapping portion 123, and is then mounted to the housing 11 together with the plug fixing portion 12 to be electrically connected to the first terminal 101.

In a specific implementation, the avoidance groove 122 may be in communication with the at least one first fixing portion 121. When the plug fixing portion 12 is connected to the housing 11, the second terminal and/or the third terminal 13 are/is snapped into the avoidance groove 122 or the first fixing portion 121 to be electrically connected to the first terminal 101. In this way, the second terminal and the third terminal 13 may be inserted from the avoidance groove 122 side or the first fixing portion 121 side according to an actual need to be electrically connected to the first terminal 101. Therefore, the assembling is flexible.

For example, the avoidance groove 122 may be in communication with the first fixing portion 121 referenced as X5 in the figure, so as to form a bidirectional socket at X5.

During the assembling, the third terminal 13 may be snapped into the avoidance groove 122 to be electrically connected to the first terminal 101, and the second terminal may be snapped into the first fixing portion 121 at X5 or another location to be electrically connected to the first terminal 101.

Alternatively, the third terminal 13 may be snapped into the first fixing portion 121 at X5 to be electrically connected to the first terminal 101, and the second terminal may be snapped into the first fixing portion 121 at another location to be electrically connected to the first terminal 101.

In a variation, the avoidance groove 122 may be in communication with the plurality of first fixing portions 121. During the assembling, the third terminal 13 and the second terminal may be both snapped into the avoidance groove 122 to be electrically connected to the first terminal 101.

Alternatively, the third terminal 13 and the second terminal may be both directly snapped into the first fixing portion 121 to be electrically connected to the first terminal 101, and the avoidance groove 122 avoids at least the third terminal 13.

In a specific implementation, an opening direction of the avoidance groove 122 is opposite to an opening direction of the at least one first fixing portion 121, so as to meet the connection requirements of different terminals. The opening direction may be a direction in which the terminal is inserted into the avoidance groove 122 or the first fixing portion 121.

For example, the opening direction of the avoidance groove 122 faces the control panel 10, and the opening direction of the first fixing portion 121 faces away from the control panel 10.

During the assembling, the terminal (that is, the third terminal 13) of the first to-be-connected member 14 disposed in the housing 11 may be inserted into the avoidance groove 122. In this way, the first to-be-connected member 14 can be completely electrically connected to the first terminal 101 in the housing 11. For another example, the terminal (that is, the second terminal) of the second to-be-connected member disposed outside the housing 11 may be inserted into the first fixing portion 121, so as to realize electrical connection to the first terminal 101 outside the housing 11.

In a specific implementation, referring to FIG. 1, the third terminal 13 may be inserted into the first fixing portion 121 along the y direction to be electrically connected to the first terminal 101. Therefore, the third terminal 13 and the second terminal are inserted into the plug fixing portion 12 in a same direction.

Further, a wall 1 1a of the housing 11 on which the opening 111 may be provided has an accommodating portion 112. The accommodating portion 112 is configured for the wire harness 15 to span. When the plug fixing portion 12 is connected to the housing 11, a part of the wire harness 15 is located in the housing 11, and a remaining part of the wire harness 15 spans the accommodating portion 112 to outside of the housing 11. An end portion of the wire harness 15 outside the housing 11 forms the third terminal 13. In this way, the accommodating portion 112 can protect the wire harness 15. In particular, the accommodating portion protects the part of the wire harness 15 spanning over the wall 11a of the housing 11 from being squeezed and damaged by an external force.

For example, the accommodating portion 112 may be formed by a notch provided on an upper edge of the wall 11a and extending toward the opening 111.

In a specific implementation, the first to-be-connected member 14 may be located above the control panel 10, and a projection area of the first to-be-connected member 14 facing the control panel 10 at least partially overlaps with the control panel 10. Therefore, a space utilization of the housing 11 is high, thereby facilitating miniaturization of the control box assembly 1.

For example, referring to FIG. 2, the first to-be-connected member 14 may be erected above the control panel 10 by a fixing frame 17.

In a variation, the first to-be-connected member 14 may alternatively be located below the control panel 10.

Based on the above, by means of this implementation, a number of times of inserting and removing the terminal connected to the control panel 10 during production and assembling can be reduced. In this way, the assembling efficiency is improved and the defect rate caused by the frequent insertion and removal of the terminal is reduced. Specifically, the plug fixing portion 12 is detachably connected to the housing 11. In this way, the plug fixing portion 12 can be pre-assembled independent of the housing 11. For example, the second terminal may be pre-fixed to the plug fixing portion 12 to realize pre-assembling. Then the plug fixing portion 12 and the second terminal may be mounted to the housing 11 together during the assembling, so as to realize electrical connection between the second terminal and the first terminal 101.

Although specific implementations have been described above, these implementations are not intended to limit the scope of the present disclosure, even if only one implementation is described with respect to specific features. The feature example provided in the present disclosure is intended to be illustrative rather than limiting, unless otherwise stated. In specific implementations, the technical features of one or more dependent claims may be combined with the technical features of the independent claims, and the technical features from the corresponding independent claims may be combined in any appropriate manner, rather than only in the specific combinations listed in the claims.

Although the present invention is disclosed above, the present invention is not limited thereto. Any person skilled in the art can make various changes and modifications without departing from the spirit and the scope of the present invention, and therefore the protection scope of the present invention should be subject to the scope defined by the claims.

## Claims

1. A control box assembly (1), **characterized by** comprising a control panel (10) and a housing (11), wherein at least a part of the control panel (10) is disposed in the housing (11);
the housing (11) has an opening (111);
the part of the control panel (10) located in the housing (11) comprises a first terminal (101), and the first terminal (101) is located at the opening (111) or in a projection area of the opening (111) facing inside of the housing (11);
the control box assembly (1) further comprises a plug fixing portion (12), and the plug fixing portion (12) is detachably connected to the housing (11) to reveal or cover the opening (111); and
the plug fixing portion (12) comprises at least one first fixing portion (121), the first fixing portion (121) is configured to fix a second terminal, and the second terminal is electrically connected to the first terminal (101) when the plug fixing portion (12) is connected to the housing (11).

2. The control box assembly (1) according to claim 1, **characterized in that** the first terminal (101) comprises a conductive contact piece (102), the second terminal comprises a snap opening that is at least partially conductive, and the conductive part of the snap opening is in physical contact with the conductive contact piece (102) when the plug fixing portion (12) is connected to the housing (11).

3. The control box assembly (1) according to claim 2, **characterized in that** the conductive contact piece (102) is located at an edge of the control panel (10) close to the opening (111).

4. The control box assembly (1) according to any of the preceding claims, **characterized by** further comprising: a third terminal (13) electrically connected to the first terminal (101), wherein the plug fixing portion (12) comprises an avoidance groove (122), and the third terminal (13) is located in the avoidance groove (122) when the plug fixing portion (12) is connected to the housing (11).

5. The control box assembly (1) according to claim 4, **characterized in that** the avoidance groove (122) is provided on a side of the plug fixing portion (12) facing the opening (111) and extends away from the control panel (10).

6. The control box assembly (1) according to any of the preceding claims 4 to 5, **characterized in that** the avoidance groove (122) comprises a snapping portion (123), and the third terminal (13) is snapped-fitted to the avoidance groove (122) to be electrically connected to the first terminal (101) when the plug fixing portion (12) is connected to the housing (11).

7. The control box assembly (1) according to any of the preceding claims 4 to 6, **characterized in that** the avoidance groove (122) is in communication with the at least one first fixing portion (121), and when the plug fixing portion (12) is connected to the housing (11), the second terminal and/or the third terminal (13) are/is snapped into the avoidance groove (122) or the first fixing portion (121) to be electrically connected to the first terminal (101).

8. The control box assembly (1) according to any of the preceding claims 4 to 7, **characterized by** further comprising: a first to-be-connected member (14), wherein the first to-be-connected member (14) is disposed in the housing (11), and when the plug fixing portion (12) is connected to the housing (11), the first to-be-connected member (14) is electrically connected to the first terminal (101) by the third terminal (13).

9. The control box assembly (1) according to any of the preceding claims 4 to 8, **characterized by** further comprising: the third terminal (13) is inserted into the first fixing portion (121) along a first direction and is electrically connected to the first terminal (101), wherein the first direction is a direction in which the plug fixing portion (12) points to the control panel (10).

10. The control box assembly (1) according to claim 9, **characterized in that** a wall (11a) of the housing (11) on which the opening (111) is provided has an accommodating portion (112), the accommodating portion (112) is configured for a wire harness (15) to span, when the plug fixing portion (12) is connected to the housing (11), a part of a wire harness (15) is located in the housing (11), and a remaining part of the wire harness (15) spans the accommodating portion (112) to outside of the housing (11), and an end portion of the wire harness (15) outside the housing (11) forms the third terminal (13).

11. The control box assembly (1) according to any of the preceding claims, **characterized in that** the plug fixing portion (12) comprises a body (124), the first fixing portion (121) is formed by a through hole (125) running through the body (124) along a first direction, and the first direction is a direction in which the plug fixing portion (12) points to the control panel (10).

12. The control box assembly (1) according to any of the preceding claims, **characterized in that** the housing (11) comprises a buckling portion (113), the plug fixing portion (12) comprises a buckling mating portion (126), and the buckling portion (113) is mated with the buckling mating portion (126) to detachably connect the plug fixing portion (12) to the housing (11).

13. The control box assembly (1) according to claim 12, **characterized in that** the buckling mating portion (126) comprises a first buckling mating portion (127) located on one end (12a) of the plug fixing portion (12) and a second buckling mating portion (128) located on an other end (12b) of the plug fixing portion (12); and the buckling portion (113) comprises a first buckling portion (114) adapted to the first buckling mating portion (127) and a second buckling portion (115) adapted to the second buckling mating portion (128).

14. The control box assembly (1) according to claim 13, **characterized in that** the first buckling portion (114) is a T-shaped member or an L-shaped member, the first buckling mating portion (127) is a U-shaped member, and when an opening of the U-shaped member is inserted into a longitudinal section of the T-shaped member or the L-shaped member, an end portion of the U-shaped member abuts against a transverse section of the T-shaped member or the L-shaped member.

15. The control box assembly (1) according to any of the preceding claims 12 to 14, **characterized in that** each of the buckling mating portions (126) comprises a deformable portion (129) bendable or compressible by an external force.
